**Europäisches Patentamt**

**European Patent Office**

**Office européen des brevets**

(11) Publication number: **0 162 656**
**B1**

(12) **EUROPEAN PATENT SPECIFICATION**

(45) Date of publication of patent specification: **17.10.90**

(51) Int. Cl.5: **B 23 B 27/14, C 23 C 28/04**

(21) Application number: **85303397.5**

(22) Date of filing: **14.05.85**

(54) **Multilayer coated cemented carbides.**

(30) Priority: **14.05.84 JP 94716/84**

(43) Date of publication of application:
**27.11.85 Bulletin 85/48**

(45) Publication of the grant of the patent:
**17.10.90 Bulletin 90/42**

(84) Designated Contracting States:
**DE FR GB SE**

(56) References cited:
**EP-A-0 074 759**
**EP-A-0 093 706**
**DD-C-156 717**
**DE-A-1 521 528**
**GB-A-2 048 960**
**US-A-4 052 530**
**US-A-4 357 382**

**PATENT ABSTRACTS OF JAPAN, vol. 6, no. 214**
**(C-131) 1092r, 27th October 1982; & JP-A-57 120**
**667 (SUMITOMO DENKI KOGYO K.K.) 27-07-**
**1982**

(73) Proprietor: **SUMITOMO ELECTRIC INDUSTRIES
LIMITED**
**No. 15, Kitahama 5-chome Higashi-ku
Osaka-shi Osaka 541 (JP)**

(72) Inventor: **Nakano, Minoro**
**c/o Itami Works of Sumitomo Electric Ind. Ltd.
1-1, Koyakita 1-chome Itami-shi Hyogo (JP)**
The other inventor has agreed to waive his
entitlement to designation

(74) Representative: **Bizley, Richard Edward et al
BOULT, WADE & TENNANT 27 Furnival Street
London EC4A 1PQ (GB)**

(56) References cited:
**PATENT ABSTRACTS OF JAPAN, vol. 6, no. 227
(C-134) 1105r, 12th November 1982; & JP-A-57
131 359 (HITACHI KINZOKU K.K.) 14-08-1982**

**PATENT ABSTRACTS OF JAPAN, vol. 1, no. 157,
14th December 1977, page 3370 C 77; & JP-A-52
96 912 (MITSUBISHI KINZOKU) 15-08-1977**

Courier Press, Leamington Spa, England.

## Description

This invention relates to coated cemented carbides of high water resistance and toughness. More particularly, it is preferably concerned with multilayer coated cemented carbides suitable for cutting tools which can be used at a high cutting speed, e.g. exceeding 300 m/min, for a long period of time.

Cemented carbides coated with one or more layers consisting essentially of at least one hard material such as TiC, $Al_1O_3$ or TiN, are of high wear resistance and are well known for various uses. Moreover, it is well known that double layer coated cemented carbide tools, whose outer layer is of $Al_2O_3$, have an excellent wear resistance because of the higher heat resistance and oxidation resistance of $Al_2O_3$. Also, a multilayer a coated substrate is described in GB—A—2048960. This relates to a composite body for use as a wear resistant part or an insert in a cutting tool which consists of a substrate carrying one or more layers of hard material devoid of binder, one of which layers itself consists of a multilayer of layers of 0.02 to 0.1 μm thickness. The multilayers may be $Al_2O_3$ interleaved by layers of, for example, titanium carbide or titanium nitride.

Cutting conditions required for such cutting tools have yearly become severer and the requirement of a higher wear resistance for the cutting tools is increasing with the increase of cutting speeds, e.g. exceeding 300 m/min. For this requirement, efforts have been made to increase the thickness of an $Al_2O_3$ layer. However, $Al_2O_3$ itself is a brittle material, so the increase of its film thickness results often in lowering of the toughness and accordingly, a cutting tool using a cemented carbide coated with an increased thickness of $Al_2O_3$ layer is lacking in toughness unsatisfactory in a widely available tool requiring both the wear resistance and toughness.

An article having a wear surface coated with a layer of aluminium oxide codeposited with titanium oxide is described in US—A—4052530. The coating is stated to exhibit most of the desirable features of alumina and also to exhibit the lubricating qualities of titanium oxide leading to an increased usable lifetime because the reduced friction lowers wear.

The present invention can enable the provision of new coated cemented carbides of both high wear resistance and toughness.

The present invention can enable the provision of a cemented carbide alloy coated with a multilayer of $Al_2O_3$, which is free from the problem of decreased toughness.

The inventors have made efforts to use the high wear resistance of an $Al_2O_3$ layer in an increased thickness without lowering the toughness. They have found that alternate layering of $Al_2O_3$ layers and interlayers is effective for this purpose, each of the $Al_2O_3$ layers containing titanium oxide in the form of a solid solution or mixed crystal. The present invention is based on this finding.

Accordingly, the present invention provides a multilayer coated cemented carbide comprising a substrate of cemented carbide, an inner layer contacted with the surface of the substrate and an outer layer contacted with the inner layer, the said inner layer being at least one layer consisting of at least one carbide, nitride, carbonitride, carboxynitride, oxynitride, boronitride or borocarbonitride of Ti, and the said outer layer being a multilayer with a total thickness of 3 μm to 20 μm, consisting of a plurality of $Al_2O_3$ layers each having a thickness of 0.01 to 2 μm, each consisting of an $Al_2O_3$ film in which titanium oxide is dissolved and being respectively divided by interlayers each having a thickness of 0.01 to 2 μm and each consisting of at least one TiC, TiN, TiCN, TiCNO, TiCO, TiNO, Ti oxides, Ti(B, N), Ti(B, N, C), SiC, AlN and AlON.

In a preferred embodiment of the present invention, the above described multilayer of the outer layer may have an outermost layer with a thickness of 0.1 to 5 μm, consisting of at least one member selected from the group consisting of nitrides of Ti, Zr and Hf, BN and AlN.

There are three co-effective means for preventing an $Al_2O_3$ coating layer with an increased thickness from having a decreased toughness:

1) The $Al_2O_3$ coating layer is not composed of pure $Al_2O_3$, but is composed of a solid solution of $Al_2O_3$ with titanium oxide.

2) The $Al_2O_3$ coating layer is a multilayer coating structure comprising $Al_2O_3$ layers having a total thickness of 5 to 20 μm, each $Al_2O_3$ layer having a thickness of 0.01 to 2 μm, and divided by interlayers each having a thickness of 0.01 to 2 μm, and each consisting of at least one member selected from the group consisting of TiC, TiCN, TiN, TiCNO, TiNO, Ti oxides, Ti(B, N), Ti(B, N, C), SiC, AlN and AlON and, optionally

3) The above described multilayer contains an outermost layer with a thickness of 0.1 to 5 μm, consisting of at least one member selected from the group consisting of nitrides of Ti, Zr and Hf, BN and AlN.

These three means will be described in further detail:

1) The wear or abrasion resistance of $Al_2O_3$ is increased with the purity thereof if the grain size is constant, while on the other hand, the toughness is not improved by the purity. However, the inventors have found a method wherein the toughness of $Al_2O_3$ is surprisingly increased by somewhat decreasing the wear resistance thereof, that is, by dissolving Ti oxide in $Al_2O_3$ to form generally $(AlTi)_2O_3$. According to this method, the wear resistance is somewhat lowered, but the toughness is remarkably improved. Therefore, the lowering of the wear resistance can be prevented by increasing the film thickness of $Al_2O_3$ without lowering the toughness of a tool as a whole. The Ti present in $Al_2O_3$ in the form of the solid solution or Ti oxides serves to increase the adhesiveness of the $Al_2O_3$ layer to the interlayer provided above or below the $Al_2O_3$ layer.

Ideally, it is desired that Ti oxide is dissolved in $Al_2O_3$ up to the limit of solid solution, preferably in a proportion of 0.01 to 0.1 vol%, but a similar effect can be given even if it is uniformly precipitated with an amount of 30 vol% or less, preferably 10 to 0.1 vol%. Formation of a solid solution of Ti oxide in $Al_2O_3$ is suitably carried out by a method comprising feeding simultaneously a Ti halide or organo Ti compound during formation of $Al_2O_3$ by chemical vapor deposition.

2) The formation of a solid solution of Ti oxide in an $Al_2O_3$ film is effective for increasing the toughness of the film, but an increased film thickness results in coarsening of the grain size of $Al_2O_3$ and thus lowering of the wear resistance and toughness. In particular, there is a frequent occurrence of coarse grains or columnar crystals at the edge of a cutter, where the growth speed of $Al_2O_3$ is higher, and the edge part meets with a marked abrasion or breakage. The inventors have made various studies on this problem and have thus found that this problem can be solved by the following means. That is, the $Al_2O_3$ layer with a total thickness ranging from 5 to 20 μm is divided into a plurality of layers each having a thickness of 0.01 to 2 μm by the use of interlayers. Each of the interlayers has a thickness of 0.01 to 2 μm and consists of at least one member selected from the group consisting of TiC, TiN, TiCN, TiCNO, TiCO, TiNO, Ti oxides, Ti(B, N), Ti(B, N, C), SiC, AlN and AlON. When each of the $Al_2O$ layers divided by the interlayers has a thickness of 0.01 to 2 μm, there takes place no coarsening of grain and thus the wear resistance and toughness can be held. If the thickness exceeds 2 μm, grain coarsening takes place, while if less than 0.01 μm, the interlayers above and beneath an $Al_2O_3$ layer tend to be bonded to provide such a state that $Al_2O_3$ grains float in the interlayers. In this case, the toughness is improved but the wear resistance is unfavourably lowered.

If the total thickness of the $Al_2O_3$ layers is less than 5 μm, increase of the wear resistance does not occur, while if more than 20 μm, unfavourable stripping of the films takes place. A preferred range of total film thickness if 5 to 10 μm. When the wear resistance is not taken into serious consideration, a total thickness of 3 μm or more can be employed.

Each interlayer serves the purpose of not only preventing enlargement of the grain size of $Al_2O_3$, but also forming a composite structure wherein $Al_2O_3$ and the interlayer strengthen each other so as to increase the toughness. That is, the interlayer having a higher strength and toughness than $Al_2O_3$ is capable of stopping cracks propagating in the $Al_2O_3$ film or reducing the propagation speed thereof and finally preventing cracks from propagation in the interior of the substrate. The thickness of the interlayer should be 0.01 to 2 μm, since if less than 0.01 μm, the effect of preventing propagation of cracks cannot be given while if more than 2 μm, the effect of $Al_2O_3$ is decreased to lower the wear resistance. While the interlayer is formed as a thin film, it is not necessarily formed in and laminar structure, but may occassionally be formed in a structure such as island-dotted in the interface with the $Al_2O_3$ layer. In this structure, the effects or advantages of the present invention can also be obtained.

3) In a preferred embodiment of the present invention, an outermost layer with a thickness of 0.1 to 5 μm, consisting of at least one member selected from the group consisting of nitrides of Ti, Zr and Hf, BN and AlN is provided on the outer layer of the $Al_2O_3$ layers divided by the interlayers as set forth above.

Since the coating composed of at least one of Ti, Zr and Hf nitrides, BN and AlN has a high toughness, it is capable of preventing propagation of cracks occurring on the surface or in the coating films to the inside of the substrate or to the surface during cooling or cutting, or reducing the propagation speed thereof, and thereby protecting the cutting tool from an abnormal wearing or chipping due to stripping or loss of the coatings.

Use of BN is preferred. Coating a hard BN film having an Hv hardness of 3000 kg/mm² or more and keeping the film thickness of the lower layers to at most 10 μm, can provide a tool having a very high wear resistance.

As apparent from the foregoing detailed illustration, the multilayer-coated extrahard alloy of the present invention is excellent in toughness as well as wear or abrasion resistance and may be used as a material for a high speed cutter giving a much longer life than the prior art alloys.

The following examples are given in order to illustrate the present invention in detail without limiting the same.

Example 1

A cemented carbide consisting of 85 wt% of WC, 10 wt% of (Ti, Ta, W)C and 5 wt% of Co was used as a substrate and subjected to a multilayer coating in a CVD apparatus at a temperature of 1000°C and a reduced pressure of 10 Torr with holding gaseous atmospheres, i.e. a mixed gaseous stream consisting of 5 vol% of $AlCl_3$, 5 vol% of $CO_2$ and the balance of $H_2$ for $Al_2O_3$ layers, a mixed gaseous stream consisting of 5 vol% of $TiCl_4$, 10 vol% of $CH_4$ and the balance of $H_2$ for TiC layers and a mixed gaseous stream consisting of 5 vol% of $TiCl_4$, 10 vol% of $N_2$ and the balance of $H_2$ for TiN layers. The reaction time was suitably controlled depending on the film thickness, thus obtaining multilayer coated cemented carbides (A), (B) and (C) each having the film thickness structure as shown in Table 1.

When the $Al_2O_3$ layer was formed, 10 vol% of $TiCl_4$ was doped to dissolve Ti in the $Al_2O_3$ or 15 vol% of $TiCl_4$ was doped to precipitate 5 vol% of $Ti_2O_3$ in the $Al_2O_3$.

For comparison, a cemented carbid (D) coated with an inner layer of 3 μm TiC and an outer layer of 5 μm $Al_2O_3$ and another cemented carbide (E) coated with an inner layer of 3 μm TiC and an outer layer of 10 μm $Al_2O_3$ were prepared.

3

## TABLE 1

| Sample | Inner Layer | Outer Layer | Outermost Layer |
|---|---|---|---|
| A | 3 μm TiC | 4 laminated layers (Al$_2$O$_3$ total film thickness 6 μm) consisting of 1.5 μm Al$_2$O$_3$ layers (Ti dissolved) and 0.5 μm TiC interlayers | 0.5 μm TiN |
| B | 3 μm TiC | 12 laminated layers (Al$_2$O$_3$ total film thickness 6 μm) consisting of 0.5 μm Al$_2$O$_3$ layers (Ti dissolved) and 0.5 μm TiC interlayers | 10 μm TiN |
| C | 3 μm TiC | 5 laminated layers (Al$_2$O$_3$ total film thickness 10 μm) consisting of 2 μm Al$_2$O$_3$ layers (coexistence with 5 vol % of Ti$_2$O$_3$) and 0.1 μm TiN interlayers | 3 μm TiN |
| D | 3 μm TiC | 5 μm Al$_2$O$_3$ | |
| E | 3 μm TiC | ±0 μm Al$_2$O$_3$ | |

The resulting insert samples (A) to (E) were then subjected to cutting test by the following conditions:

| | |
|---|---|
| cutting speed | 300 m/min |
| feed | 0.30 mm/rev |
| depth of cut | 2 mm |
| workpiece | SCM 435 H (H$_B$ 280) |

As a result of this cutting test, Sample A, B and C of the present invention showed cutting times amounting to a flank wear of 0.3 mm of 10, 11 and 18 minutes respectively, while Comparative Sample D was abnormally worn in 1 minute and Comparative Sample E was broken and of no good use at the initial stage.

## Example 2

A cemented carbide consisting of 85 wt% of WC, 5 wt% of (Ti, W)C, 5 wt% of TiN and 5 wt% of Co was used as a substrate (Insert Form: SNMG 432). The flank face side of the insert was of a WC—Co phase in a region of from the surface to a thickness of 20 μm and of three phases of WC, Co and B1 type solid solution in another region inside therefrom. This cemented carbide was coated with an inner layer of 1 μm SiC or TiC, an outer layer comprising 5 laminated layers of Al$_2$O$_3$ (Ti dissolved) with a total thickness of 10 μm, each having a thickness of 2 μm and being divided by interlayers of TiCNO, AlON or Ti(BN) each having a thickness of 0.5 μm, and an outermost layer of 1 μm TiN, ZrN, AlN or BN (hexagonal).

Comparative Samples were prepared by coating the same substrate with an inner layer of 1 μm SiC or TiCN, an outer layer of 10 μm Al$_2$O$_3$ and an outermost layer of 1 μm TiN.

The resulting insert samples were subjected to cutting test in the similar conditions to Example 1 to obtain results as shown in Table 2:

TABLE 2

| Inner Layer | Outer Layer | Outermost Layer | Life (cutting no feasible time) (min) |
|---|---|---|---|
| Present Invention | | | |
| 1 μm SiC | 10 μm $Al_2O_3$ (Ti dissolved) + TiCNO | 1 μm TiN | 9 |
| -do- | 10 μm $Al_2O_3$ (Ti dissolved) + AlCN | -do- | 8 |
| -do- | 10 μm $Al_2O_3$ (Ti dissolved) + Ti (BN) | -do- | 11 |
| -do- | 10 μm $Al_2O_3$ (Ti dissolved) + TiCNO | -do- | 10 |
| -do- | 10 μm $Al_2O_3$ (Ti dissolved) + Al (CN) | 1 μm ZrN | 9 |
| -do- | 10 μm $Al_2O_3$ (Ti dissolved) + Ti (BN) | 1 μm AlN | 9 |
| -do- | 10 μm $Al_2O_3$ (Ti dissolved) + Ti (BN) | 1 μm BN | 7 |
| Comparison | | | |
| 1 μm Sic | 10 μm $Al_2O_3$ | 1 μm TiN | broken in 30 sec. |
| 1 μm TiC | -do- | -do- | broken in 1 sec. |

### Example 3

The cemented carbide alloy of Example 2 was coated with an inner layer of 1 μm TiC, an outer layer with a total $Al_2O_3$ film thickness of 5 μm (Ti dissolved) and with interlayers of 0.5 μm TiC and an outermost layer of a hard BN film with an Hv hardness of 3000 kg/mm$^2$ and with a thickness of 3 μm by plasma CVD method, and then subjected to cutting test under the similar conditions to Example 1. The cutting was feasible for 15 minutes.

### Claims

1. A multilayer coated cemented carbide comprising a substrate of cemented carbide, an inner layer contacted with the surface of the substrate and an outer layer contacted with the inner layer, the said inner layer being at least one layer consisting of at least one carbide, nitride, carbonitride, carboxynitride, oxynitride, boronitride or borocarbonitride of Ti, and the said outer layer being a multilayer with a total thickness of 3 μm to 20 μm, consisting of a plurality of $Al_2O_3$ layers each having a thickness of 0.01 to 2 μm, each consisting of an $Al_2O_3$ film in which titanium oxide is dissolved and being respectively divided by interlayers each having a thickness of 0.01 to 2 μm and each consisting of at least one of TiC, TiN, TiCN, TiCNO, TiCO, TiNO, Ti oxides, Ti(B, N), Ti(B, N, C), SiC, AlN and AlON.

2. A multilayer coated cemented carbide is claimed in claim 1, wherein the outer layer is further coated with an outermost layer with a thickness of 0.1 to 5 μm, consisting of at least one member selected from the group consisting of nitrides of Ti, Zr and Hf, BN and AlN.

3. A multilayer coated cemented carbide as claimed in claim 2, wherein the outermost layer is a hard BN film with an Hv hardness of at least 3000 kg/mm$^2$.

4. A multilayer coated cemented carbide as claimed in any one of claims 1 to 3, wherein the titanium oxide is dissolved in the $Al_2O_3$ film in a proportion of 0.01 to 0.1 vol% to form a solid solution.

5. A multilayer coated cemented carbide as claimed in any one of claims 1 to 4, wherein the outer layer is a multilayer with a total thickness of 5 μm to 20 μm.

6. A process for the preparation of a multilayer coated cemented carbide as claimed in any one of claims 1 to 5, wherein the $Al_2O_3$ film containing dissolved titanium oxide is prepared by feeding simultaneously a titanium halide or organo titanium compound when Al$_2$O$_3$ is formed by chemical vapor deposition.

7. A cutting tool comprising a multilayer coated cemented carbide as claimed in any one of the preceding claims.

**Patentansprüche**

1. Mit einem mehrlagen Überzug versehenes Metall- oder Sinterkarbid (Hartmettal), mit einer Metallkarbidbasis, einer inneren Schicht, die an der Oberfläche der Basis anliegt, und einer äußeren Schicht, die an der inneren Schicht anliegt, wobei die innere Schicht mindestens eine Schicht aufweist, die mindestens aus Karbid, Nitriden, Carbonitriden, Carboxynitriden, Oxynitriden, Bornitriden oder Borcarbonitriden von Ti besteht, und die äußere Schicht eine Mehrfachschicht mit einer Gesamtdicke von 3 µm bis 20 µm ist, die aus einer Mehrzahl von Al$_2$O$_3$-Schichten besteht, die je eine Dicke von 0,01 bis 2 µm aufweisen und je aus einem Al$_2$O$_3$-Film bestehen, in welchem Titanoxid gelöst ist, und je durch Zwischenschichten getrennt sind, von denen jede eine Dicke von 0,01 bis 2 µm aufweist und aus mindestens einem von TiC, TiN, TiCN, TiCNO, TiCO, TiNO, Ti-Oxiden, Ti(B, N), Ti(B, N, C), SiC, AlN oder AlON besteht.

2. Sinterkarbid nach Anspruch 1, dadurch gekennzeichnet, daß die äußere Schicht ferner mit einer äußersten Schicht mit einer Dicke von 0,1 bis 5 mm beschichtet ist, die aus mindestens einem aus den Nitriden von Ti, Zr und Hf, BN und AlN besteht.

3. Sinterkarbid nach Anspruch 2, dadurch gekennzeichnet, daß die äußerste Schicht ein harter BN-Film mit einer Hv-Härte von mindestens 3000 kg/mm ist.

4. Sinterkarbid nach einem der Ansprüche 1 bis 3, dadurch gekennzeichnet, daß Titanoxid in dem Al$_2$O$_3$-Film in einem Verhältnis von 0,01 bis 0,1 Vol.-% gelöst ist, um eine feste Lösung zu bilden.

5. Sinterkarbid nach einem der Ansprüche 1 bis 4, dadurch gekennzeichnet, daß sich die äußere Schicht eine Mehrfachschicht mit einer Gesamtdicke von 5 bis 20 µm ist.

6. Verfahren zur Herstellung eines mit einer Mehrfachschnitt überzogenen Sinterkarbids, nach einem der Ansprüche 1 bis 5, wobei der Al$_2$O$_3$-Film gelöstes Titanoxid enthält und durch das gleichzeitige Zuführen eines Titanhalogenids oder einer organischen Titanverbindung hergestellt wird, wenn Al$_2$O$_3$ durch chemisches Aufdampfen erzeugt wird.

7. Schneidwerkzeug mit einem Sinterkarbid mit einem Mehrschichtüberzug, gekennzeichnet, durch die kennzeichnenden Merkmale eines der vorhergehenden Ansprüche.

**Revendications**

1. Carbure cémenté pourvu d'un revêtement à couches multiples comportant un substrat de carbure cémenté, une couche intérieure en contact de la surface du substrat et une couche extérieure en contact de la couche intérieure, ladite couche intérieure étant au moins une couche consistant en au moins un carbure, un nitrure, un carbonitrure, un carboxynitrure, un oxynitrure, un boronitrure ou un borocarbonitrure de Ti, et ladite couche extérieure étant une multicouche avec une épaisseur totale de 3 µm à 20 µm, consistant en une pluralité de couches d'Al$_2$O$_3$ possédant chacune une épasseur de 0,01 à 2 µm, consistant chacune en un film d'Al$_2$O$_3$ dans laquelle de l'oxyde de titane est dissous et étant respectivement divisée par des couches intermédiaires possédant chacune une épaisseur de 0,01 à 2 µm et consistant chacune en au moins un des eléments TiC, TiN, TiCN, TiCNO, TiCO, TiNO, des oxydes de Ti, Ti(B, N), Ti(B, N, C), SiC, AlN et AlON.

2. Carbure cémenté pourvu d'un revêtement à couches multiples selon la revendication 1, dans lequel la couche extérieure est en outre revêtue d'une couche externe de 0,01 à 5 µm d'épaisseur, consistant en au moins un élément choisi parmi le groupe constitué par des nitrures de Ti, Zr et Hf, BN, et AlN.

3. Carbure cémente pourvu d'un revêtement à couches multiples selon la revendication 2, dans lequel la couche externe est un film de BN dur avec une dureté Hv d'au moins 3000 kg/mm$^2$.

4. Carbure cémente pourvu d'un revêtement à couches multiples selon l'une quelconque des revendications 1 à 3, dans lequel l'oxyde de titane est dissous dans le film d'Al$_2$O$_3$ dans une proportion de 0,01 à 0,1% en volume pour former une solution solide.

5. Carbure cémente pourvu d'un revêtement à couches multiples selon l'une quelconque des revendications 1 à 4, dans lequel la couche extérieure est une multicouche d'épaisseur totale de 5 µm à 20 µm.

6. Procédé de préparation d'un carbure cémente pour vu d'un revêtement à couches multiples selon l'une quelconque des revendications 1 à 5, dans lequel le film d'Al$_2$O$_3$ contenant de l'oxyde de titane dissous est préparé par apport simultané d'un halogénure de titane ou d'un composé organotitane lorsque l'Al$_2$O$_3$ est formé par dépôt en phase vapeur.

7. Outil de coupe comportant un carbure cémente pourvu d'un revêtement à couches multiples selon l'une quelconque des revendications précédentes.